# FASCICULE DE BREVET EUROPEEN

(11) **EP 1 042 813 B1**
(45) Date de publication et mention de la délivrance du brevet: **06.01.2010**
(21) Numéro de dépôt: 99932974.1
(22) Date de dépôt: 26.07.1999
(51) Int. Cl.: H01L 27/12, H01L 21/20, G02F 1/136, G02F 1/1333

(54) **DISPOSITIF COMPRENANT UNE PUCE SEMI-CONDUCTRICE A SUBSTRAT ISOLANT ET TRANSPARENT**
HALBLEITERSCHALTUNG MIT EINEM ISOLIERENDEN UND TRANSPARENTEN SUBSTRAT
DEVICE COMPRISING A SEMICONDUCTOR CHIP WITH INSULATING AND TRANSPARENT SUBSTRATE

(30) Priorité: 28.07.1998 FR 9809662
(43) Date de publication de la demande: 11.10.2000
(73) Titulaire: Pollard, Jean, 91140 Villebon-sur-Yvette (FR)
(72) Inventeur: POLLARD, Jean, Pierre, F-91140 Villebon sur Yvette (FR)
(74) Mandataire: Pontet, Bernard
(86) Numéro de dépôt international: PCT/FR1999/001831
(87) Numéro de publication internationale: WO 2000/007243

(56) Documents cités:
- EP-A- 0 474 474
- EP-A- 0 553 860
- SPANGLER L J ET AL: "A BULK SILICON SOI PROCESS FOR ACTIVE INTEGRATED SENSORS" SENSORS AND ACTUATORS A, vol. A24, no. 2, 1 juillet 1990 (1990-07-01), pages 117-122, XP000148921
- PATENT ABSTRACTS OF JAPAN vol. 013, no. 232 (E-765), 29 mai 1989 (1989-05-29) -& JP 01 039733 A (SEIKO EPSON CORP), 10 février 1989 (1989-02-10)

## Description

Les circuits intégrés ou « puces » ont des applications innombrables et constituent des composants plus ou moins banals selon les applications envisagées.

Une puce est, en soi, un ensemble complexe formé de plusieurs parties, en particulier un substrat de base sur lequel sont organisés en grand nombre les éléments actifs et passifs microscopiques qui donnent à la puce ses caractéristiques fonctionnelles.

On comprend, cependant, que le substrat n'est pas indifférent et que ses caractéristiques physiques et chimiques sont déterminantes, au moins pour certaines applications.

Dans ce qui suit, on utilise l'expression « substrat originel » pour désigner le substrat, sa composition et sa structure, tel qu'il existe avant les premières étapes de fabrication concernant plus spécifiquement les éléments actifs et passifs microscopiques de la puce.

La présente invention concerne, comme on le verra plus loin en détails, aussi bien le substrat originel, la puce et les dispositifs auxquels une telle puce peut être associée, du fait des caractéristiques qu'elles procurent à ces dispositifs.

On connaît déjà des puces dont les éléments actifs et passifs microscopiques sont réalisés par des procédés de fabrication semi-conducteurs considérés comme standards, mettant en oeuvre des températures élevées, de l'ordre de 1 100 °C, qui exigent, évidemment, que la structure soit compatible avec ces contraintes thermiques sévères, ce qui est le cas des substrats semi-conducteur monocristallin, de type silicium ayant une épaisseur d'au moins 400 µm (micromètres).

Cette structure est, de loin, la plus répandue car elle permet aux puces de couvrir la quasi totalité des applications de l'électronique : microprocesseurs, mémoires, etc.

En revanche, ces puces ne peuvent pas être utilisées dans les applications qui supposent qu'elles puissent être traversées par la lumière du fait que le substrat originel n'est pas transparent (au moins dans le spectre visible).

De même, le substrat originel étant, par nature, semi-conducteur n'est pas isolant et est impropre aux applications nécessitant des fréquences élevées (hautes fréquences ou hyperfréquences) qui exigent un isolement parfait des éléments fonctionnels associés au substrat.

On connaît aussi des puces fabriquées à ces températures élevées, mais selon des procédés spécifiques non standards et donc chers. à partir de substrats originels qui comprennent une couche très mince (quelques fractions de µm) de silicium semi-conducteur monocristallin associée par croissance cristalline (épitaxie) à un substrat transparent isolant monocristallin, de type saphir ou corindon.

Malheureusement, des défauts sont induits dans la couche mince épitaxiée, d'où il résulte une diminution sensible des performances attendues pour les éléments fonctionnels.

Le substrat originel coûte très cher et son prix, ajouté à celui de la mise en oeuvre non standard, donne aux puces ainsi réalisées un prix prohibitif pour les applications envisagées.

En fait, ces puces ont des qualités marquées quant à leur résistance aux radiations et leurs applications sont, dans la pratique, cantonnées au domaine nucléaire et au domaine spatial qui admettent des prix élevés car l'essentiel est d'atteindre le but recherché et non de comprimer les prix de revient, ce qui n'est évidemment pas le cas en matière commerciale sur des marchés concurrentiels.

Certains procédés de fabrication non standards prévoient des températures plus basses que celles rappelées ci-dessus, à savoir moins de 600 °C, ce qui permet d'adopter d'autres structures, notamment une couche très mince (quelques fractions de µm) de silicium semi-conducteur amorphe ou polycristallin déposé chimiquement en phase vapeur sur un substrat transparent isolant en silice ou en verre.

Les éléments actifs réalisés dans un matériau amorphe ou polycristallin sont très lents et totalement impropres aux circuits fonctionnant en logique à haute fréquence et en analogique en hyperfréquences. Des dispositifs optoélectroniques de type connu tels que les écrans à cristaux liquides à matrice active ne peuvent pas être ainsi fabriqués sous forme de puce intégrant toutes les fonctions d'adressage des écrans.

Il existe également des puces semi-conductrices comprenant un substrat semi-conducteur sur lequel les éléments fonctionnels sont fixés avec interposition d'une couche isolante mais cette couche est trop mince pour procurer une véritable isolation en haute fréquence et en hyperfréquence, car elle n'a que quelques µm d'épaisseur, voire même quelques fractions de µm, ce qui est sans comparaison avec ce que serait un substrat isolant de plusieurs centaines de µm.

Il existe aussi des puces semi-conductrices dont la structure comprend d'une part une couche mince (quelques fractions de µm) d'un semi-conducteur monocristallin de type silicium et comprenant les très nombreux éléments fonctionnels, et d'autre part une couche mince d'isolant, cet ensemble étant originellement intégré à la surface d'un support de silicium monocristallin pour créer un substrat de type standard non isolant, non transparent, connu sous le sigle *SOI* (Semi-conductor On Insulator).

Ensuite, par un véritable postprocessus, cet ensemble est désolidarisé de son substrat originel pour être reporté et fixé à un autre support final épais (400 µm et plus) isolant et transparent, au moyen d'un adhésif organique.

Après l'obtention des éléments fonctionnels proprement dits selon un procédé standard, il est nécessaire de mettre en oeuvre ce postprocessus selon les phases suivantes :
a) coller le recto des deux couches minces sur une face d'un mannequin plan de manipulation, avec une colle provisoire,
b) amincir mécaniquement le support originel opaque, par retrait de matière pour l'éliminer, à l'opposé du mannequin,
c) éliminer ce qui reste de ce support originel opaque, après amincissement mécanique, par des moyens physico-chimiques, jusqu'à mettre à jour la mince couche isolante,
d) coller cette couche mince isolante sur un support final isolant et transparent, généralement en verre ou en silice, au moyen d'un adhésif organique, isolant et transparent (lequel ne pourrait pas supporter la haute température nécessaire à la fabrication des éléments fonctionnels),
e) retirer le mannequin en le décollant des deux couches minces.

Selon une variante du postprocessus, on n'utilise pas un mannequin mais directement un support final isolant et transparent, on amincit le premier, opaque, et on le retire, de sorte que finalement l'ensemble des deux couches minces est fixé au second support isolant et transparent par la face qui est généralement la face extérieure.

Ce postprocessus est très complexe et difficilement automatisable, d'où il résulte des prix de revient, élevés.

La document EP-A-0 474 474 décrit un dispositif LCD selon le préambule de la revendication 1. Le document: SANGLER L J ET AL: "A BULK SILICON SOI PROCESS FOR ACTIVE INTEGRATED SENSORS" SENSORS AND ACTUATORS A, vol. A24, no. 2, 1 juillet 1990 (1990-07-01), pages 117-122, décrit un détecteur de pression avec une couche barrière autour du substrat.

La présente invention propose une solution nouvelle permettant de réaliser des puces sur un substrat originel de type SOI bon marché, ayant un support isolant et transparent, et dont la structure permet d'utiliser des processus de fabrication standards.

A cette fin, l'invention a pour objet un dispositif à circuit intégré ou « puce » du type décrit dans la revendication 1.

Selon d'autres caractéristiques de l'invention :
⇒ le dispositif est associé à des moyens d'éclairage situés du côté opposé à celui par lequel il doit être observé, soit directement, soit par projection ;
⇒ le dispositif est intégré à un appareil tel qu'un radiotéléphone portable ;
⇒ le dispositif constitue un ensemble enfichable amovible muni d'organes de connexion à un appareil tel qu'un radiotéléphone ;
⇒ le dispositif est associé à une monture de lunettes, à raison d'un pour chaque oeil, selon une disposition symétrique et axiale mais non centrale ;
⇒ le dispositif est associé à un miniprojecteur à écran de surface décimétrique.

L'invention sera mieux comprise par la description détaillée ci-après faite en référence au dessin annexé. Bien entendu, la description et le dessin ne sont donnés qu'à titre d'exemple indicatif et non limitatif.

La figure 1 est une vue schématique en coupe d'un substrat originel SOI de type connu comportant une couche mince d'un produit semi-conducteur monocristallin fixée à une couche d'isolant inorganique mince, le tout étant intégré à la surface d'un support épais de silicium monocristallin opaque.

La figure 2 est une vue schématique en coupe d'une puce de type connu, réalisée à partir du substrat originel de la figure 1, après retrait du support originel non isolant opaque et report sur un support final isolant transparent.

La figure 3 est une vue schématique en coupe d'un substrat conforme à l'invention, apte aux procédés de fabrication semi-conducteurs standards et possédant des qualités spécifiques.

La figure 4 est une vue schématique en coupe d'un circuit intégré, ou puce, conforme à l'invention, après réalisation des éléments fonctionnels, actifs et passifs, montrant la présence de zones transparentes permettant la transmission de la lumière.

La figure 5 est une vue schématique en coupe montrant un composant optoélectronique, de type puce-écran transmissive, dont l'essentiel est une puce conforme à l'invention.

La figure 6 est une vue schématique d'un micro écran complet, composé d'une puce-écran transmissive, d'un dispositif d'éclairage et d'une optique de visée.

La figure 7 est une vue schématique montrant l'intégration du micro écran de la figure 6 à un radiotéléphone portable.

La figure 8 est une vue schématique montrant l'intégration du micro écran de la figure 6 à un petit boîtier indépendant, muni de broches de connexion et susceptible d'être enfiché dans un port d'un appareil qui, ici, est un radiotéléphone portable.

Les figures 9 et 10 sont des vues schématiques illustrant l'association de deux micro écrans conforme à l'invention, à des lunettes.

La figure 11 est une vue schématique d'un ensemble de micro projection conforme à l'invention, basé sur une puce-écran transmissive conforme à l'invention.

La figure 12 est une vue schématique d'un micro projecteur intégrant l'ensemble de la figure 10, et permettant la projection de l'image née de la puce-écran sur un écran de visualisation directe, de plus grandes dimensions.

Pour pouvoir réaliser un dispositif conforme à l'invention, il faut disposer d'un substrat qui en constitue en quelque sorte le coeur, et qui doit être obtenu par des moyens de fabrication standards pour être proposé à des prix accessibles.

Un tel substrat n'existe pas actuellement.

Selon la matière choisie pour chacune des parties formant un substrat (dont son support) et selon le procédé utilisé pour les associer, on obtient des résultats différents les uns des autres, eu égard aux paramètres suivants :
- transparence ou opacité du substrat,
- absence ou présence d'aberrations optiques,
- absence ou présence de capacités parasites pour les éléments fonctionnels,
- isolation électrique nulle, médiocre ou excellente,
- robustesse mécanique plus ou moins grande,
- fabrication standard ou spécifique,
- prix de revient élevé ou raisonnable.

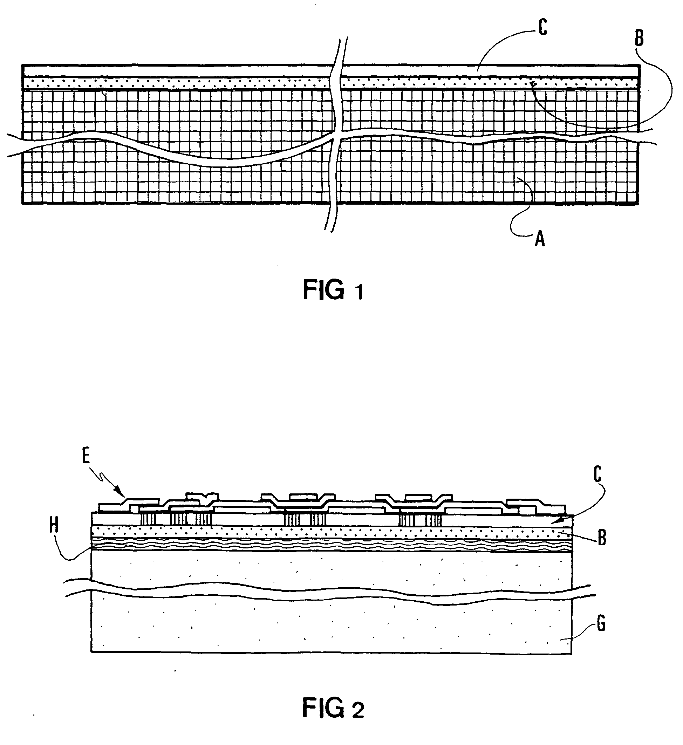

En se reportant à la figure 1, on voit un substrat SOI de type existant formé de trois parties élémentaires, à savoir un support A qui est épais car il doit être mécaniquement robuste, mais opaque et non isolant, une couche mince isolante inorganique B et une couche mince C d'une matière inorganique semi-conductrice, monocristalline, généralement en silicium, dans laquelle sont créés les éléments fonctionnels microscopiques de la puce.

Comme on l'a montré dans le préambule de la présente description, aucun des substrats connus ne répond positivement aux exigences cumulatives suivantes :
- transparence du substrat,
- absence d'aberrations optiques,
- absence de capacités parasites pour les éléments fonctionnels,
- excellente isolation électrique,
- bonne robustesse mécanique,
- fabrication standard,
- prix de revient raisonnable. car certains de ces substrats ne sont obtenus qu'à des prix prohibitifs, d'autres ne sont pas transparents, ou bien ont de médiocres qualités d'isolation, etc.

Pour obtenir à la fois un substrat qui résiste aux températures élevées, et des puces transparentes, on part du substrat SOI de la figure 1, on ouvrage la couche semi-conductrice C à haute température pour y créer des éléments fonctionnels E.

Après fabrication des éléments E, on retire le support originel opaque et non isolant A jusqu'à dégagement complet de la couche isolante B, puis on applique ensemble les couches B isolante et C ouvragée sur un support transparent et isolant G, avec interposition d'une couche d'adhésif organique H qui serait incapable de supporter la haute température du procédé de fabrication des éléments fonctionnels E.

On aboutit ainsi à une structure qui est représentée sur la figure 2.

L'invention permet, précisément, de satisfaire simultanément toutes ces exigences, malgré les incompatibilités reconnues comme telles par l'Homme de Métier.

L'une des conditions à remplir est d'opérer selon les procédés de fabrication semi-conducteurs standards, parmi lesquels il faut éliminer ceux qui réunissent des matériaux à coefficients de dilatation différents, car le seul moyen de surmonter cette difficulté est d'agir à température modérée (environ 600 °C), ce qui n'est pas conforme aux procédés standards.

De plus, il se trouve que cette méthode ne permet pas d'atteindre les objectifs voulus, de sorte qu'il faut utiliser un procédé mettant en oeuvre une haute température (environ 1.100 °C) pour l'obtention d'éléments fonctionnels performants dans une couche de matériau semi-conducteur inorganique et monocristallin.

Les substrats fabriqués par de tels procédés, doivent répondre à des exigences très sévères.

L'une de ces exigences est la nécessité absolue qu'ils n'exfusent aucune trace, même infime, d'ions de certains éléments, à savoir ceux qui sont regroupés dans les colonnes Ia, IIa, IIIa et

Va de la Classification Périodique des Eléments Chimiques de Mendeleïev.

Pour constituer le support, on pourrait alors utiliser le quartz qui n'est formé que de silicium et d'oxygène mais, justement, le coefficient de dilatation du quartz est très différent de celui des matériaux semi-conducteurs inorganiques et monocristallins en couche mince.

Lorsque le substrat doit être transparent et, en outre, avoir un coefficient de dilatation égal à celui de la couche mince monocristalline semi-conductrice, le matériau le mieux adapté est un verre dont l'élaboration artificielle permet d'ajuster son coefficient de dilatation, et qui est transparent par nature, alors qu'un élément naturel fini, tel que le saphir, a un coefficient donné et non modifiable.

Lorsqu'un tel verre risque d'exfuser des ions indésirables, il faut lui appliquer une couche barrière.

Une autre exigence des procédés de fabrication standards, provient des automatismes mis en oeuvre et parmi lesquels se trouvent les opérations de détection et de repérage. Les substrats standards étant opaques, les robots de fabrication sont conçus pour utiliser cette propriété, de sorte qu'un substrat transparent exigerait la construction de machines spéciales.

L'invention nécessite que le substrat originel soit transparent, qu'il porte une couche semi-conductrice monocristalline, ainsi qu'un isolant efficace et qu'il soit mécaniquement robuste, le tout étant obtenu par des procédés standards et sans qu'il soit nécessaire de compléter la fabrication proprement dite par des opérations de postprocessus et de finition complexes, délicates et coûteuses.

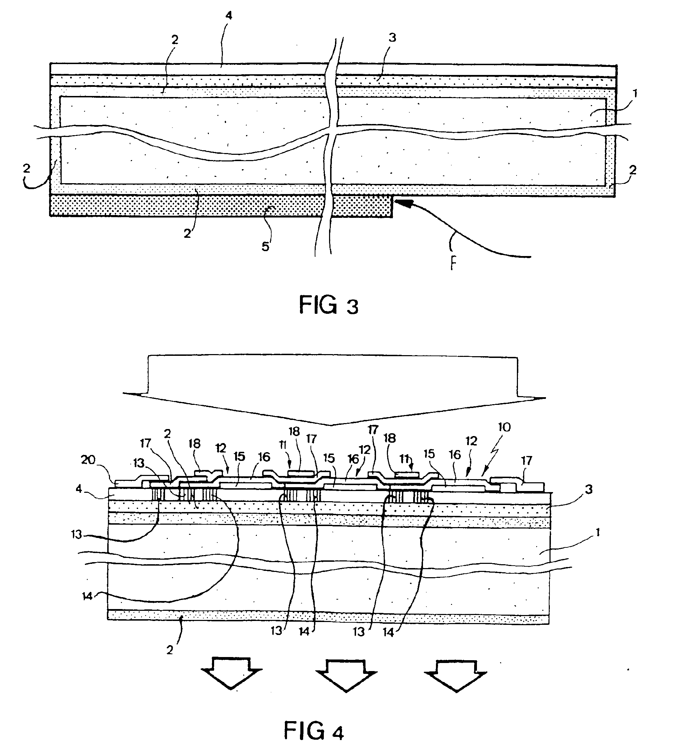

Une fois terminé le support 1 en verre spécial, le substrat originel est créé par une procédé standard de type SOI déjà cité, et comprend alors (figure 3) :
◆ le support 1 en verre spécial réfractaire,
◆ une couche mince continue 2 de matériau transparent, ayant un effet barrière vis-à-vis des ions indésirables éventuellement libérés par le verre du support 1, qui recouvre les deux faces et la tranche du support 1 pour l'enrober complètement,
◆ une couche intermédiaire mince 3 d'un matériau inorganique isolant et transparent,
◆ une couche supérieure mince 4 d'un matériau semi-conducteur inorganique et monocristallin,
◆ une couche inférieure 5 d'un matériau réfractaire optiquement.opaque.

Le support 1 provient de plaques de verre spécial réfractaire d'une épaisseur de 0,5 millimètre ou plus, dont le coefficient de dilatation est ajusté par le fabricant à celui de la couche 4 au moins.

Après découpage, les plaques sont éventuellement polies pour assurer un parallélisme rigoureux et un état de surface de qualité dite « miroir » pour les deux grandes faces.

Ensuite, les plaques sont découpées en disques de différents diamètres selon les demandes (100 millimètres et plus), avec finition des bords de découpe.

La couche barrière 2, isolante et transparente, par exemple du nitrure de silicium, est alors déposée par des moyens physico-chimiques.

On met en place les couches 3 et 4 par un procédé SOI connu en soi, la couche isolante 3 étant intimement solidarisée à la couche barrière 2 par collage moléculaire dudit procédé SOI.

Enfin, on dispose la couche réfractaire opaque 5, par exemple du silicium amorphe ou polycristallin, sur la face inférieure du support 1-2, c'est-à-dire à l'opposé du sous-ensemble 3-4, par dépôt électrochimique .

La structure du substrat originel est alors terminée et il peut suivre le processus de fabrication semi-conducteur standard, à haute température, de fabrication des éléments fonctionnels microscopiques des puces.

La fabrication consiste à enchaîner de nombreuses opérations de photogravure, de dépôt, de microlithographie, etc., afin de créer les éléments fonctionnels actifs et passifs, à savoir des transistors, des connexions, des grilles de commande etc., par des moyens connus en soi et utilisés en micro-électronique.

Ainsi, la couche 4 comprend toute la micro-électronique sur une épaisseur extrêmement faible de l'ordre de 1,5 µm, à laquelle le silicium est transparent, étant rappelé que le silicium peut être retiré sélectivement, notamment lors d'une opération de gravure.

Sur la figure 4, on voit la structure réalisée après ouvraison de la couche 4, qui est issue du substrat originel de la figure 3.

La puce présente sur sa face supérieure une matrice désignée globalement par la référence 10, et formée de lignes et de colonnes opaques 11, déterminant entre elles des zones transparentes 12. Dans la couche de semi-conducteur monocristallin 4, se trouvent des éléments actifs microscopiques 13 et 14. Des éléments isolants ou semi-conducteurs passifs 15 et 16 se trouvent au droit des zones transparentes 12. Enfin, en lignes et en colonnes se trouvent des éléments passifs 17 et 18.

Quand toutes les opérations sont terminées et que l'opacité du substrat est devenue inutile, on retire la couche opaque provisoire 5, comme l'évoque la flèche F de la figure 3, pour l'éliminer.

Après retrait de la couche opaque 5, on dispose d'une puce qui constitue un composant complet renfermant tous les éléments de commande nécessaires à son fonctionnement et qui est globalement transparent. L'épaisseur de cette puce est d'environ ½ millimètre.

On voit qu'ainsi l'invention a pour résultat important de permettre la réalisation de toute la logique, la connectique et les commandes voulues sur une seule puce dont la fabrication reste compatible avec les procédés existants.

Il faut noter que les transistors sont placés en périphérie de chaque zone transparente, de sorte qu'ils ne contrarient pas la libre transmission de la lumière, et la puce est bien transmissive.

Chaque zone transparente 12 et ses éléments fonctionnels périphériques constituent ensemble une cellule.

A chaque croisement ligne-colonne, se trouve un élément actif microscopique 13-14 de commande de chaque cellule, dans chacune desquelles se trouve aussi une électrode individuelle transparente 15.

A la périphérie de la matrice 10, se trouvent les circuits de commande des éléments actifs et, au-delà, les plots 20 pour la connexion de la puce au circuit électronique de l'appareil équipé.

On peut penser que l'évolution technologique permettra de diminuer le pas des cellules, qui est actuellement de 15 µm, jusqu'à un facteur 10, c'est-à-dire que, selon cette hypothèse, une surface donnée posséderait 10 X 10 = 100 fois plus de cellules procurant une résolution d'image très améliorée.

Pour réaliser une puce-écran, la puce décrite précédemment doit être associée à un cristal liquide et les zones transparentes 12 constituent autant de pixels dits « pixels transmissifs.

Selon l'invention, le cristal liquide est intégré à une structure de quelques microns (micromètres) d'épaisseur, ce qui permet de s'affranchir de nombreux inconvénients inhérents à la technologie actuelle. En particulier, il n'est pas nécessaire d'avoir une couche d'ancrage pour l'orientation des cristaux, et l'on a plus besoin de polariseurs pour commander la transmission/occultation de la lumière.

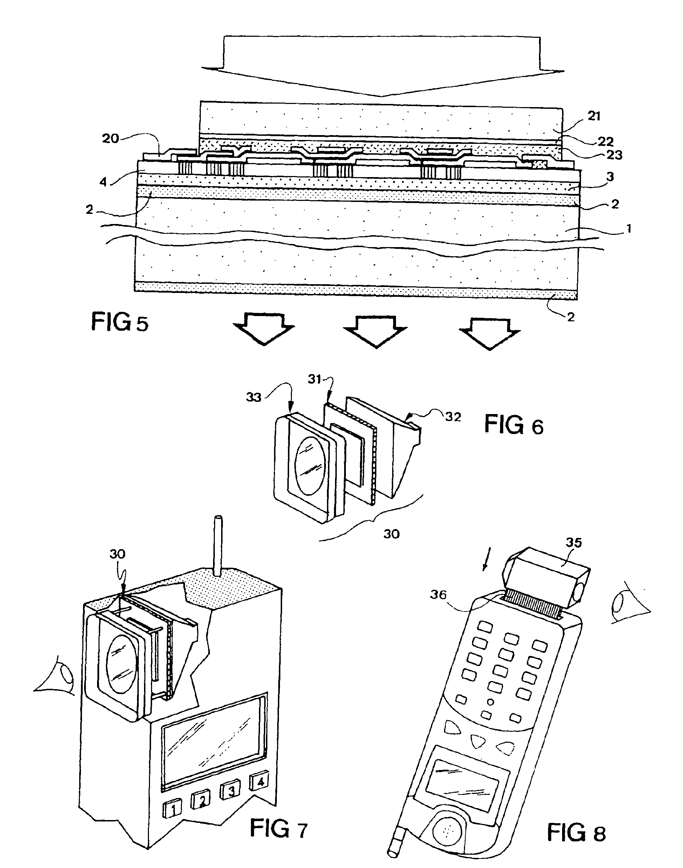

En se reportant maintenant à la figure 5, on voit que la puce de la figure 4 est complétée par une fenêtre en verre 21, munie d'une contre-électrode transparente 22, la structure 23 contenant le cristal liquide étant interposée entre la contre-électrode 22 et la puce proprement dite.

La contre-électrode 22 permet de maintenir le potentiel de référence pour l'établissement d'un champ électrique à travers la structure 23 contenant le cristal liquide. Cette contre-électrode 22 est réalisée en oxyde d'indium-étain qui est un matériau conducteur et transparent.

Les caractéristiques de la lumière transmise sont commandées à chaque pixel transmissif 12 au moyen des variations d'un champ électrique généré entre l'électrode transparente 15 de chaque pixel transmissif 12 et la contre-électrode 22, selon les signaux de commande aboutissant à la puce par ses plots de connexion 20.

Sur la figure 6, on voit qu'un composant complet constituant un micro-écran 30 basé sur la puce-écran de la figure 5, désignée par la référence globale 31, est placée entre un dispositif d'éclairage arrière 32 et une optique frontale 33, ce qui est mis en évidence grâce à la présentation du composant en vue éclatée.

Le dispositif d'éclairage 32 est lui-même composé d'une ou plusieurs diodes électroluminescentes et d'une optique de collimation (non visibles sur le dessin) et procure une lumière monochrome ou trichrome, selon que l'on souhaite obtenir des images en noir et blanc ou des images en couleurs.

L'optique frontale est plus ou moins complexe mais comprend essentiellement un viseur à agrandissement.

Convenablement pilotée par une électronique de commande, la puce-écran 31 peut offrir à l'observateur des images fixes ou animées, en noir et blanc ou en couleurs d'une excellente qualité, étant donné le nombre très important de pixels transmissifs 12 qui permettent une très bonne résolution et un très bon « piqué » de l'image.

La possibilité d'animation des images et la présence de couleurs dépendent de la rapidité de réaction du matériau électro-optique (cristaux liquides). L'animation en couleurs exige une plus grande rapidité de réaction que l'animation en noir et blanc et à fortiori que des images fixes.

On comprend que pour l'observateur qui approche son oeil de l'optique 33, la puce-écran 31 éclairée en transparence produit une image virtuelle (au sens optique du terme) qui est l'équivalent de celle d'un grand écran observé de loin.

La distance apparente de ce grand écran virtuel (au sens courant du terme) peut être, selon l'optique 33 choisie, établie entre quelques décimètres et l'infini.

Etant donné que toute la lumière produite par le dispositif d'éclairage arrière 32 est transmise à la rétine de l'oeil de l'observateur, la puissance d'éclairage peut rester très modeste, ce qui est précisément un grand avantage dans le domaine de la miniaturisation.

En effet, le micro-écran 30 peut être très petit, 1 à 3 cm³ par exemple, du fait de la répartition harmonieuse des éléments complémentaires à la puce écran 31, de part et d'autre de celle-ci.

On peut souligner qu'une puce-écran de type connu, non transparente, qui ne peut pas transmettre la lumière mais qui la réfléchit (la puce est alors dite « réflective »), oblige à disposer du même côté de la puce réflective le dispositif d'éclairage et l'optique de visée, ce qui conduit nécessairement à une construction moins compacte et plus volumineuse.

En se reportant à la figure 7. on voit le micro-écran 30 de la figure 6 intégré à un appareil qui, ici, est un radiotéléphone portable.

Cette intégration suppose donc que l'appareil soit conçu dès l'origine avec le micro écran 30 et sa logique électronique.

Sur la figure 8, on voit une autre solution qui consiste à placer le micro-écran 30 dans un petit boîtier indépendant 35 muni de broches 36 de type normalisé pour pouvoir assurer l'enfichage du boîtier 35 dans un port lui-même normalisé, prévu ici sur un radiotéléphone portable.

Ainsi, le boîtier 35 est amovible et peut être connecté ou pas à un ou plusieurs appareils différents, lesquels peuvent être quelconques dès lors qu'ils possèdent un port compatible avec les broches 36.

L'encombrement modeste et la faible consommation d'énergie du micro-écran 30 permettent son association à des appareils compacts et portables, en particulier des radiotéléphones numériques qui peuvent aisément permettre des connexions lointaines, ce qui met l'usager en mesure de se connecter à des réseaux du genre INTERNET, à des systèmes du genre MINITEL ou à toutes sortes de bases de données puisque c'est le radiotéléphone qui reçoit les signaux numériques générant des images affichées sur la puce-écran.

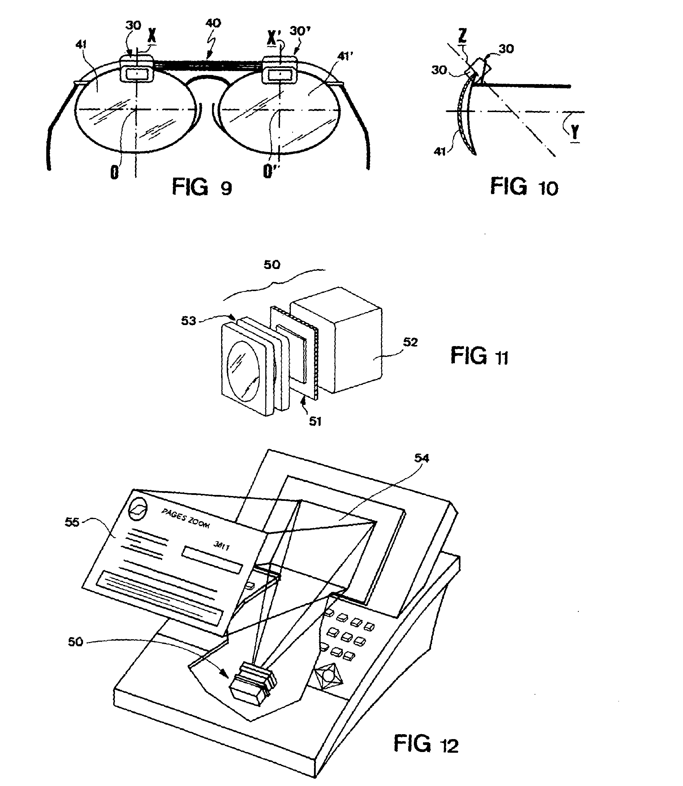

En raison de ces mêmes qualités d'encombrement et de consommation minimes, il est possible, selon les figures 9 et 10, de placer sur une monture légère de lunettes 40 un micro écran 30 - 30' à la partie supérieure et dans l'axe x - x' de chacun des deux verres 41 et 41', mais pas dans leur centre O - O', afin de ne pas gêner la vision normale de l'usager.

Ainsi, les zones centrales, gauches, droites et basses sont entièrement dégagées, ce qui autorise la vision binoculaire normale, les verres 41 - 41' pouvant d'ailleurs être de simples vitres sans correction optique.

Par rapport à l'axe de vision normale y supposé horizontal, l'axe z de chaque micro-écran 30 - 30' est incliné afin d'être convergent avec l'axe de vision y sensiblement sur la pupille des yeux de l'usager, de sorte que celui-ci peut simplement en levant les yeux, observer les deux micro-écrans 30 et 30' et bénéficier des images qu'il souhaite y observer, sans perdre la vision périphérique d'alerte grâce à laquelle il peut instantanément reprendre sa vision normale en cas de nécessité, en baissant les yeux jusqu'à leur position voulue.

Naturellement, les micro écrans 30 et 30' doivent être connectés à une logique électronique, ce qui peut être obtenu en leur adjoignant une liaison filaire ou bien en les dotant de récepteurs d'émissions hertziennes ou de rayonnement infrarouge.

La figure 11 est une vue éclatée qui illustre une variante selon laquelle la puce transmissive, désignée par la référence globale 51, est associée à un dispositif de projection 50.

Un dispositif d'éclairage arrière 52 doit être plus puissant que le dispositif 32.

Une optique frontale 53 tout à fait différente du viseur de la figure 6, comprend des moyens de projection de lumière.

Le projecteur 50 peut être intégré à un ensemble complet tel que celui représenté sur la figure 12 qui montre que les images formées sur la puce écran 31 sont projetées et réfléchies par une optique de renvoi 54 et aboutissent à un écran 55 de visualisation directe .

Cet écran 55 peut avoir une surface de quelques décimètres carrés, par exemple le format courant des écrans d'ordinateurs portables.

Cet ensemble de projection est largement plus avantageux et plus économique que les écrans connus constitués par des tubes cathodiques encombrants ou alors par des écrans plats coûteux.

On comprend que l'invention couvre le support en verre, le substrat originel, la puce, la puce-écran, le micro-écran et tout dispositif auquel ces éléments peuvent être intégrés.

Dans la pratique, l'ensemble de la figure 6 constitue un composant complet apte à être commercialisé en tant que tel mais la puce-écran en elle-même, la puce, la structure du cristal liquide et le substrat en lui-même constituent des pièces détachées pouvant être mises dans le commerce séparément.

En outre, il ressort clairement de la description ci-dessus que tous ces éléments concourent à la réalisation d'appareils plus complexes, qu'ils dotent de performances inconnues à ce jour.

Bien entendu, beaucoup d'applications autres que celles décrites sont possibles, puisque le micro-écran rend exactement les mêmes services qu'un écran banal, mais en étant très miniaturisé.

## Revendications

1. Dispositif à circuit intégré comprenant :
- un support originel (1) réfractaire, isolant et transparent,
- une première couche semi-conductrice (4) formée par du silicium, ou du silicium-germanium, monocristallin dont l'épaisseur est suffisamment fine pour que ladite première couche (4) soit transparente,
- des éléments fonctionnels actifs (13-14) présents dans ladite première couche mince,
- des éléments fonctionnels passifs transparents (15-16) supportés par ladite première couche mince,
- d'autres éléments fonctionnels (17-18) opaques qui sont disposés ponctuellement pour laisser subsister des cellules transparentes (12) par lesquelles de la lumière du spectre visible peut librement traverser le circuit intégré dans son ensemble,
- une seconde couche mince (3) d'un matériau inorganique transparent, électriquement isolant et réfractaire, interposé entre ledit support originel (1) et la dite première couche mince (4) de matériau semiconducteur monocristallin,
- des transistors disposés à la périphérie des cellules transparentes (12),
- des cristaux liquides contenus dans un matériau mince, pour constituer une structure unitaire (23), cette structure unitaire (23) étant intercalée entre le dispositif circuit intégré proprement dit et une contre électrode (22) transparente formée par une couche mince appliquée contre une fenêtre transparente (21), cet ensemble constituant un dispositif à puce-écran transmissive,
**caractérisé en ce que** ledit support originel (1) a un coefficient de dilatation thermique égal à celui de la dite première couche mince (4) de matériau semiconducteur monocristallin;
et **en ce que** le support originel (1) est en verre réfractaire recouvert sur toutes ses faces d'une couche réfractaire et transparente (2) ayant un effet barrière à l'égard de certains éléments chimiques présents dans le support (1), afin de les y confiner.

2. Dispositif micro-écran comprenant un dispositif selon la revendication 1 et des moyens d'éclairage (32-52) situés sur un côté dudit dispositif qui est opposé au côté d'observation.

3. Appareil électronique tel qu'un radiotéléphone portable, comprenant un dispositif selon la revendication 2.

4. Ensemble enfichable amovible (35) comprenant un dispositif selon la revendication 2 et muni d'organes de connexion (36) à un appareil tel qu'un radiotéléphone portable.

5. Monture de lunettes (40) comprenant un dispositif selon la revendication 2 pour chaque oeil selon une disposition symétrique et axiale mais non centrale.

6. Miniprojecteur à écran d'aire décimétrique comprenant un dispositif selon la revendication 2.

## Claims

1. An integrated circuit device comprising:
- a refractory, insulating and transparent original support (1)
- a first semiconductor layer (4) layer formed of silicon, or silicon-germanium, monocrystalline whose thickness is sufficiently thin that the said first layer (4) is transparent,
- active functional elements (13-14) contained in said first thin layer,
- transparent passive functional elements (15-16) supported by said first thin layer,
- other opaque functional elements (17-18) being punctually arranged over said thin layer to allow transparent cells (12) to remain, light of the visible spectrum can freely pass through the entire integrated circuit, through said transparent cells,
- a second thin layer (3) of transparent and electrically insulating, inorganic refractory material interposed between said original support (1) and said thin layer (4) of monocrystalline semiconductor material,
- transistors disposed on the periphery of the transparent cells (12),
- liquid crystals contained in a thin material, in order to constitute a unit structure (23), said unit structure (23) being interposed between said integrated circuit device and a transparent counter-electrode (22) formed by a thin layer applied against a transparent window (21), this assembly constituting a transmissive screen-chip,
**characterised in that** said original support (1) has a coefficient of thermal expansion which is equal to a thermal expansion coefficient of said first thin layer (4) of monocrystalline semiconductor material;
and **in that** the original support (1) is made of refractory glass which is covered on all faces with a transparent and refractory layer (2) having a barrier effect with respect to certain chemical elements present in the support (1) in order to confine said chemical elements therein.

2. Micro-screen device comprising a device according to claim 1 and lighting means (32-52) situated on a side of said device that is remote from an observation side.

3. Electronic apparatus such as a portable radio-telephone, comprising a device according to claim 2.

4. A detachable plug-in assembly (35) comprising a device according to claim 2 and provided with devices (36) for connection to an apparatus such as a portable radio-telephone.

5. Spectacle frame (40) comprising a device according to claim 2 for each eye in a symmetrical and axial but non-central arrangement.

6. Mini-projector with a screen having a decimetric surface area comprising a device according to claim 2.

## Patentansprüche

1. Vorrichtung mit integrierter Schaltung, umfassend:
- einen hochtemperaturbeständigen, isolierenden und transparenten Ausgangsträger (1),
- eine erste Halbleiterschicht (4), gebildet aus Silicium oder aus Silicium-Germanium, monokristallin, wobei die Dicke derselben ausreichend fein ist, dass die erste Schicht (4) transparent ist,
- aktive Funktionselemente (13, 14), welche in der ersten dünnen Schicht vorhanden sind,
- passive transparente Funktionselemente (15, 16), welche von der ersten dünnen Schicht getragen sind,
- weitere lichtundurchlässige Funktionselemente (17, 18), welche punktuell angeordnet sind, um transparente Zellen (12) bestehen zu lassen, durch die Licht des sichtbaren Spektrums frei durch die integrierte Schaltung in ihrer Gesamtheit hindurchgehen kann,
- eine zweite dünne Schicht (3) aus einem anorganischen Material, transparent, elektrisch isolierend und hochtemperaturbeständig, welche zwischen dem Ausgangsträger (1) und der ersten dünnen Schicht (4) aus monokristallinem Halbleitermaterial angebracht ist,
- Transistoren, welche am Rand der transparenten Zellen (12) angeordnet sind,
- Flüssigkristalle, welche in einem dünnen Material enthalten sind, um eine einheitliche Struktur (23) darzustellen, wobei die einheitliche Struktur (23) eingefügt ist zwischen der integrierten Schaltung im eigentlichen Sinn und einer transparenten Gegenelektrode (22), welche durch eine dünne Schicht gebildet ist, die an einem transparenten Fenster (21) angebracht ist, wobei diese Einheit eine Vorrichtung mit lichtdurchlässigem Chip-Display darstellt,
**dadurch gekennzeichnet, dass** der Ausgangsträger (1) einen Wärmeausdehnungskoeffizienten gleich dem der ersten dünnen Schicht (4) aus monokristallinem Halbleitermaterial aufweist;
und dadurch, dass der Ausgangsträger (1) aus hochtemperaturbeständigem Glas besteht, welches auf allen seinen Flächen mit einer hochtemperaturbeständigen und transparenten Schicht (2) bedeckt ist, welche eine Barrierewirkung gegenüber bestimmten chemischen Elementen, die in dem Träger (1) vorhanden sind, aufweist, um sie dort festzuhalten.

2. Mikrodisplay-Vorrichtung, umfassend eine Vorrichtung nach Anspruch 1 und Beleuchtungsmittel (32, 52), welche an einer Seite der Vorrichtung angeordnet sind, die einer Betrachtungsseite gegenüberliegt.

3. Elektronisches Gerät, wie etwa ein portables Funktelefon, umfassend eine Vorrichtung nach Anspruch 2.

4. Ansteckbare, abnehmbare Einheit (35), umfassend eine Vorrichtung nach Anspruch 2 und versehen mit Elementen (36) zur Verbindung mit einem Gerät, wie mit etwa einem portablen Funktelefon.

5. Brillenfassung (40), umfassend eine Vorrichtung nach Anspruch 2 für jedes Auge, entsprechend einer symmetrischen und axialen, jedoch nicht zentralen Anordnung.

6. Miniprojektor mit Display mit Fläche im Dezimeterbereich, umfassend eine Vorrichtung nach Anspruch 2.
